# EUROPÄISCHE PATENTSCHRIFT

(11) **EP 0 986 704 B1**
(45) Veröffentlichungstag und Bekanntmachung des Hinweises auf die Patenterteilung: **20.11.2002**
(21) Anmeldenummer: 98933549.2
(22) Anmeldetag: 15.05.1998
(51) Int. Cl.: F02D 41/20, H01L 41/04

(54) **VORRICHTUNG UND VERFAHREN ZUM ANSTEUERN WENIGSTENS EINES KAPAZITIVEN STELLGLIEDES**
DEVICE AND METHOD FOR CONTROLLING AT LEAST ONE CAPACITIVE ACTUATOR
DISPOSITIF ET PROCEDE DE COMMANDE D'AU MOINS UN ORGANE DE REGLAGE CAPACITIF

(30) Priorität: 06.06.1997 DE 19723935
(43) Veröffentlichungstag der Anmeldung: 22.03.2000
(73) Patentinhaber: SIEMENS AKTIENGESELLSCHAFT, 80333 München (DE)
(72) Erfinder: HOFFMANN, Christian, D-93057 Regensburg (DE); FREUDENBERG, Hellmut, D-93080 Pentling (DE); GERKEN, Hartmut, D-93152 Nittendorf (DE); HECKER, Martin, D-93336 Laimerstadt (DE); PIRKL, Richard, D-93053 Regensburg (DE)
(86) Internationale Anmeldenummer: DE9801361
(87) Internationale Veröffentlichungsnummer: WO98055751

(56) Entgegenhaltungen:
- EP-A- 0 464 443
- EP-A- 0 611 881
- FR-A- 2 533 263
- PATENT ABSTRACTS OF JAPAN vol. 097, no. 009, 30. September 1997 & JP 09 112735 A (DENSO CORP), 2. Mai 1997
- PATENT ABSTRACTS OF JAPAN vol. 016, no. 467 (M-1317), 29. September 1992 & JP 04 166641 A (TOYOTA MOTOR CORP), 12. Juni 1992

## Beschreibung

Die Erfindung betrifft eine Vorrichtung zum Ansteuern wenigstens eines kapazitiven Stellgliedes, insbesondere eines Kraftstoff-Einspritzventils einer Kraftfahrzeug-Brennkraftmaschine, nach dem Oberbegriff von Anspruch 1. Die Erfindung betrifft auch Verfahren zum Betreiben dieser Vorrichtung (siehe Ansprüche 4 - 10).

Eine Vorrichtung nach dem Oberbegriff von Anspruch 1 ist aus DE 36 21 541 A1 bekannt. Dort werden für die Lade- bzw. Auswahlschalter und Entladeschalter Thyristoren verwendet. Diese müssen beim Einschalten mit einem Impuls gezündet werden und erlöschen von selbst, wenn der über sie fließende Leistungsstrom zu Null wird. Problematisch ist die relativ große Freiwerdezeit der Thyristoren. Dem kann begegnet werden, wenn die Thyristoren durch MOSFET-Schalter und Dioden ersetzt werden. Für N-MOSFET-Schalter ist jedoch eine sehr aufwendige Highside-Ansteuerschaltung erforderlich; für P-MOSFET-Schalter kann zwar die Ansteuerschaltung einfacher ausgebildet sein, bei diesen entstehen jedoch etwa doppelt so hohe Verluste wie bei N-MOSFET-Schaltern.

EP 0 611 881 A1 offenbart eine Piezo-Kraftstoffeinspritzregelung, bei der die Ladespannung des Piezostellgliedes abhängig von der mittels eines Mess- und eines Steuerkondensators mit einem Sollwert verglichenen, dem Stellglied zugeführten Ladung geregelt wird.

Aus DE 19 652 801 A1 ist eine Vorrichtung zum Ansteuern wenigstens eines kapazitiven Stellgliedes bekannt, die einen Lade- und einen Entladekondensator aufweist, bei der die Ansteuerung des Stellgliedes bei Betriebsbeginn mit leerem Entladekondensator und damit mit etwa halber Ladespannung beginnt.

Es ist Aufgabe der Erfindung, eine Vorrichtung zum Ansteuern wenigstens eines kapazitiven Stellgliedes mit möglichst einfacher Ansteuerung zu schaffen. Aufgabe der Erfindung ist es auch, ein Verfahren zum Betreiben dieser Vorrichtung anzugeben.

Diese Aufgabe wird erfindungsgemäß durch eine Schaltung entsprechend den Merkmalen des Anspruchs 1 gelöst.

Wie diese Schaltung angewandt wird ist in den Verfahrensansprüchen 4-10 definiert.

Dabei wird auf Highside-Ladeschalter (Thyristoren oder MOSFET) verzichtet und die Ladevorgänge werden durch massebezogene Auswahlschalter ausgelöst. Der Entladekreis wird nicht über den Masseanschluß GND geführt, um einen inneren Kurzschluß der Spannungsquelle infolge des fehlenden Ladeschalters bei leitendem Entladeschalter zu verhindern.

Ein Ausführungsbeispiel der Erfindung wird nachstehend anhand einer schematischen Zeichnung näher erläutert.

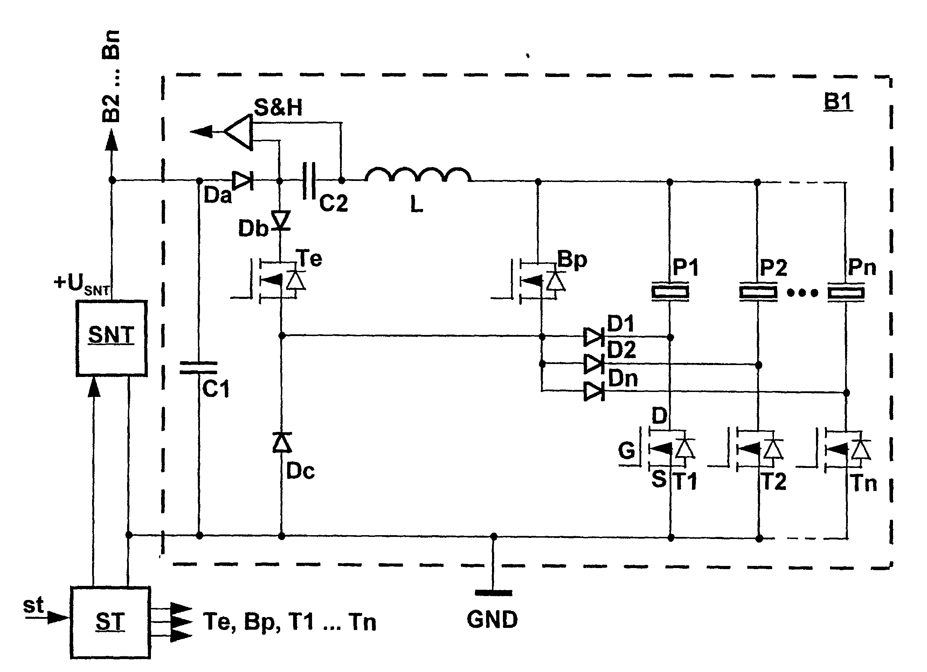

In der Zeichnung ist innerhalb eines strichlierten Kastens B1 eine Schaltung zum Ansteuern von nicht dargestellten Kraftstoff-Einspritzventilen einer Kraftfahrzeug-Brennkraftmaschine mittels kapazitiver Stellglieder P1 bis Pn dargestellt. Diese Schaltung wird von einer im Ausführungsbeispiel als Schaltnetzteil SNT ausgeführten Spannungsquelle mit Energie versorgt und von den Ausgangssignalen einer Steuerschaltung ST, welcher Steuersignale st von einem mikrocomputergesteuerten Motorsteuergerät zugeführt werden, gesteuert. Für bankweise Steuerung der Kraftstoffeinspritzung bildet die in dem eingerahmten Kasten B1 dargestellte Schaltung eine Bank; für jede Bank B2 bis Bn ist eine weitere derartige Schaltung erforderlich, die zu der in dem strichlierten Kasten B1 dargestellten Schaltung parallelzuschalten ist.

Die Schaltung besteht aus einem Ladekondensator C1, welcher dem Schaltnetzteil SNT parallelgeschaltet ist. Dem Ladekondensator C1 ist eine Reihenschaltung aus einem Entladekondensator C2, einer Umschwingspule L, einem kapazitiven Stellglied P1 und einem diesem zugeordneten Auswahlschalter T1 parallelgeschaltet.

Für jedes weitere Kraftstoffeinspritzventil ist ein Stellglied P2 bis Pn in Reihe mit seinem Auswahlschalter T2 bis Tn parallel zu der Reihenschaltung aus Stellglied P1 und Auswahlschalter T1 angeordnet.

Die in der Schaltung befindlichen Schalter Te und T1 bis Tn sind N-MOSFET-Schalter, über welche nur in einer Richtung Strom fließt.

Mit dem Verbindungspunkt zwischen den beiden Kondensatoren C1 und C2 ist der Drainanschluß eines Entladeschalters Te verbunden, dessen Sourceanschluß, über Entkopplungsdioden D1 bis Dn entkoppelt, mit den Drainanschlüssen der Auswahlschalter T1 bis Tn verbunden ist. Drain-, Source- und Gateanschluß D, S, G sind nur beim Auswahlschalter T1 eingezeichnet, um die Figur nicht zu überfrachten.

Außerdem ist ein Bypaßschalter Bp vorgesehen, auf welchen später eingegangen wird, dessen Drainanschluß mit dem Verbindungspunkt zwischen der Umschwingspule L und den Stellgliedern P1 bis Pn verbunden ist, und dessen Sourceanschluß mit dem Sourceanschluß des Entladeschalters Te verbunden ist. Sämtliche Schalter werden über ihre Gateanschlüsse von den Ausgangssignalen der Steuerschaltung ST gesteuert.

Der parallel zu den Stellgliedern P1 bis Pn angeordnete Bypaßschalter Bp wird von der Steuerschaltung ST angesteuert, wenn die Stellgliedspannung einen vorgegebenen Grenzwert überschreitet oder wenn ein in der Brennkraftmaschine bis hin zu den Leistungsendstufen der Einspritzventile auftretender Fehler erkannt wird, und entlädt die kapazitiven Stellglieder P1 bis Pn kurzschlußartig. Der Bypaßschalter Bp wird auch zum Auf- oder Nachladen des Entladekondensators C2 benötigt. Anstelle des Bypaßschalters Bp kann auch eine Diode oder Zenerdiode mit gleicher Polung wie die Inversdiode des Bypaßschalters vorgesehen sein, wobei dann aber die Aufladung des Entladekondensators C2 über eine Stellgliedbetätigung, bei einem Kraftstoffeinspritzventil vorzugsweise ohne Kraftstoffdruck, vorgenommen werden muß.

In der Schaltung sind Dioden Da und Db vorgesehen, welche Rückströme verhindern sollen. Diode Da verhindert beim Laden einen Rückstrom des negativen Anteils des sinusförmigen Ladestroms in die Spannungsquelle, der das Stellglied entladen würde. Diode Db verhindert ein Entladen des Entladekondensators C2 über die Inversdiode des Entladeschalters Te sowohl beim Entladevorgang (durch den negativen Anteil des sinusförmigen Entladestroms) als auch bei leitendem Bypaßschalter Bp.

Eine weitere, vom Minuspol GND zum Sourceanschluß des Entladeschalters Te stromleitende Diode Dc verhindert negative Spannungen an den Sourceanschlüssen des Entladeschalters Te und des Bypaßschalters Bp während des Übergangs eines der Auswahltransistoren T1 bis Tn in den nichtleitenden Zustand zum leitenden Zustand des Entladeschalters Te oder des Bypaßschalters Bp. Das ermöglicht eine einfachere Highside-Ansteuerung des Entladeschalters Te oder des Bypaßschalters Bp.

Nachstehend wird das Verfahren zum Betreiben dieser Vorrichtung beschrieben. Während des Betriebes der Schaltung ist der Ladekondensator C1 auf die von der Steuerschaltung ST bestimmte Ausgangsspannung +U_{SNT} des Schaltnetzteils SNT aufgeladen.

Bei Betriebsbeginn ist der Entladekondensator C2 entladen und die Umschwingspule L stromlos. Damit auch der Kondensator C2 vor der ersten Stellgliedbetätigung voll aufgeladen ist, werden zunächst der Bypaßschalter Bp und einer der Auswahlschalter T1 bis Tn leitend gesteuert. Dadurch entlädt sich C1 über C2, L, Bp, und beispielsweise D1 und T1. Sodann werden Bp und T1 wieder nichtleitend gesteuert und nun der Entladeschalter Te leitend gesteuert. Dadurch fließt ein Strom in Gegenrich-Bp, wodurch C2 so gepolt wird, daß an der Reihenschaltung von C1 und C2 die Summenspannung U_{C1} + U_{C2} (= Ladespannung) anliegt.

Die Spannung U_{C2} am Kondensator C2 wird über eine in diesem Ausführungsbeispiel als Sample-and-Hold-Schaltung S&H ausgebildete Meßschaltung der Steuerschaltung ST mitgeteilt und der Vorgang solange wiederholt, bis C2 auf eine vorgegebene Spannung U_{C2} aufgeladen ist.

Da die Spannung U_{C2} am Kondensator C2 bei Nichtbetätigung langsam abfällt, werden auch während des Betriebes, beispielsweise während des Ladevorgangs bei niedrigen Drehzahlen (d.h., bei zeitlich weiter auseinanderliegenden Stellgliedbetätigungen) oder im Schiebebetrieb, solche Nachladungen des Entladekondensators C2 vorgenommen.

Soll ein Einspritzvorgang stattfinden, so wird der dem entsprechenden Stellglied, beispielsweise P1, zugeordnete Auswahlschalter T1 leitend gesteuert. Es fließt Strom von +SNT und C1 über C2, L, P1 und T1 nach GND, bis das Stellglied geladen ist. Der Ladezustand des Stellgliedes P1 bleibt erhalten, solange der Auswahlschalter T1 leitet.

Wird T1 beim Verschwinden seines Steuersignals nichtleitend, und ist auch kein anderer Auswahlschalter T2 bis Tn leitend, so wird automatisch der Entladeschalter Te leitend, welcher invertiert zu den Auswahlschaltern von diesen angesteuert wird: leitet einer der Auswahlschalter T1 bis Tn, ist der Entladeschalter Te nichtleitend, und umgekehrt.

Bei leitendem Entladeschalter Te, wenn kein Stellglied betätigt wird, werden alle Stellglieder P1 bis Pn über die Umschwingspule L, den Entladeschalter Te und die Entkopplungsdioden D1 bis Dn in den Entladekondensator C2 entladen.

Die am Entladekondensator C2 anschließend anliegende Spannung U_{C2} wird über die Sample-and-Hold-Schaltung S&H der Steuerschaltung ST mitgeteilt, welche die Ausgangsspannung des Schaltnetzteils SNT nachsteuert oder nachregelt. Diese Steuerung oder Regelung kann entweder auf konstante Ladespannung U_{C1} + U_{C2} = const, auf konstante Stellgliedspannung Up = const oder auf dem Stellglied zugeführte konstante Ladung oder Energie erfolgen. Letztere Verfahren sind in den älteren deutschen Patentanmeldungen mit den Aktenzeichen DE 19652801 A1 und DE 19652807 A1 beschrieben. Anschließend kann der Ladevorgang des nächsten Stellgliedes beginnen u.s.w..

Bei einem externen Kurzschluß eines Stellgliedes P1 bis Pn, welcher den zugeordneten Auswahlschalter T1 bis Tn überbrückt,entstünde bei leitendem Entladeschalter Te ein Kurzschließen des Schaltnetzteils SNT. Um dies zu vermeiden, muß die Drain-Source-Spannung des Entladeschalters Te oder der durch ihn fließende Strom (mittels eines Shunt-Widerstandes) von der Steuerschaltung überwacht werden und im Fehlerfall der Entladeschalter Te sofort nichtleitend gesteuert werden.

## Patentansprüche

1. Vorrichtung zum Ansteuern wenigstens eines kapazitiven Stellgliedes (P1 bis Pn), insbesondere für ein Kraftstoffeinspritzventil einer Brennkraftmaschine, mittels einer Steuerschaltung (ST), mit einem zwischen Pluspol (+U_{SNT}) und Minuspol (GND) einer Spannungsquelle (SNT) angeordneten Ladekondensator (C1) und mit einer parallel zu diesem Ladekondensator (C1) angeordneten Reihenschaltung aus einer Umschwingspule (L) und wenigstens einem Stellglied mit zugeordnetem Auswahlschalter (T1 bis Tn), und mit einem Entladeschalter (Te),
**dadurch gekennzeichnet,**
**daß** zwischen Ladekondensator (C1) und Umschwingspule (L) ein Entladekondensator (C2) angeordnet ist,
**daß** eine Meßschaltung (S&H) vorgesehen ist, welche die Spannung (U_{C2}) am Entladekondensator (C2) mißt und an die Steuerschaltung (ST) weitergibt,
**daß** der wenigstens eine Auswahlschalter (T1 bis Tn) ein N-MOSFET-Schalter ist, dessen Sourceanschluß (S) mit dem Minuspol (GND) der Spannungsquelle (SNT) verbunden ist,
**daß** zwischen Pluspol (+U_{SNT}) und Entladekondensator (C2) eine zum Entladekondensator (C2) hin stromleitende Diode (Da) angeordnet ist,
**daß** der Drainanschluß des als N-MOSFET-Schalter ausgebildeten Entladeschalters (Te) über eine zu ihm hin stromleitende Diode (Db) mit der Katode der Diode (Da) verbunden ist und dessen Sourceanschluß mit dem Drainanschluß (D) jedes Auswahlschalters (T1 bis Tn) über je eine Entkopplungsdiode (D1 bis Dn) verbunden ist, und
**daß**
entweder ein als N-MOSFET-Schalter ausgebildeter, vom Steuergerät steuerbarer Bypaßschalter (Bp) vorgesehen ist, dessen Drainanschluß zum Verbindungspunkt zwischen Umschwingspule (L) und Stellglied (P1 bis Pn) führt und dessen Sourceanschluß mit dem Sourceanschluß des Entladeschalters (Te) verbunden ist,
oder eine Diode oder Zenerdiode vorgesehen ist, deren Katode mit der Umschwingspule (L) und deren Anode mit dem Sourceanschluß des Entladeschalters (Te) verbunden ist.

2. Vorrichtung nach Anspruch 1, **dadurch gekennzeichnet, daß** die Spannungsquelle (SNT) als ein vom Steuergerät (ST) steuerbares Schaltnetzteil ausgebildet ist.

3. Vorrichtung nach Anspruch 1, **dadurch gekennzeichnet, daß** eine vom Minuspol (GND) zum Sourceanschluß des Entladeschalters (Te) stromleitende Diode (Dc) vorgesehen ist.

4. Verfahren zum Betreiben der Vorrichtung nach Anspruch 1, **dadurch gekennzeichnet, daß** der Entladeschalter (Te) leitend gesteuert wird, wenn keiner der Auswahlschalter (T1 bis Tn) leitend gesteuert ist.

5. Verfahren zum Betreiben der Vorrichtung nach Anspruch 1, **dadurch gekennzeichnet, daß** vor der ersten Betätigung eines Stellgliedes (P1 bis Pn) und zwischen zwei Stellgliedbetätigungen, deren zeitlicher Abstand eine vorgegebene Dauer überschreitet, der Entladekondensator (C2) auf- oder nachgeladen wird, indem wenigstens einmal gleichzeitig der Bypaßschalter (Bp) und einer der Auswahlschalter (T1 bis Tn) leitend und anschließend nichtleitend gesteuert werden, bis am Entladekondensator (C2) eine vom Steuergerät (ST) vorgegebene Spannung (U_{C2}) anliegt.

6. Verfahren zum Betreiben der Vorrichtung nach Anspruch 1, **dadurch gekennzeichnet, daß** ein Stellglied (P1 bis Pn) betätigt wird, solange der zugeordnete Auswahlschalter (T1 bis Tn) leitend gesteuert ist.

7. Verfahren zum Betreiben der Vorrichtung nach Anspruch 1, **dadurch gekennzeichnet, daß** während des Betriebes die Ausgangsspannung (+U_{SNT}) der Spannungsquelle (SNT) auf konstante Ladespannung (UC1 + UC2) oder auf konstante Stellgliedspannung (Up) gesteuert oder geregelt wird.

8. Verfahren zum Betreiben der Vorrichtung nach Anspruch 1, **dadurch gekennzeichnet, daß** während des Betriebes die Ausgangsspannung (+U_{SNT}) der Spannungsquelle (SNT)dahingehend gesteuert oder geregelt wird, daß dem jeweils betätigten Stellglied (P1 bis Pn) eine konstante Ladung oder Energie zugeführt wird.

9. Verfahren zum Betreiben der Vorrichtung nach Anspruch 1, **dadurch gekennzeichnet, daß** der Bypaßschalter (Bp) leitend gesteuert wird, wenn die Stellgliedspannung (Up) einen vorgegebenen Grenzwert überschreitet oder wenn ein Schaltungsfehler auftritt.

10. Verfahren zum Betreiben der Vorrichtung nach Anspruch 1, **dadurch gekennzeichnet, daß** der Entladeschalter (Te) nichtleitend gesteuert wird, wenn der durch seine Drain-Source-Strecke fließende Strom oder die an ihr liegende Spannung einen vorgegebenen Wert überschreitet.

## Claims

1. Device for controlling at least one capacitive final control element (P1 to Pn), in particular for a fuel injection valve for an internal combustion engine, by means of a control circuit (ST), with a charging capacitor (C1) located between a positive pole (+U_{SNT}) and the negative pole (GND) of a voltage source (SNT), and with a series circuit arranged in parallel to this charging capacitor (C1) and comprising a ring-around coil (L) and at least one final control element with an associated selection switch (T1 to Tn), and with a discharging switch (Te),
**characterised in that**
a discharging capacitor (C2) is located between the charging capacitor (C1) and the ring-around coil (L),
a measuring circuit (S&H) is provided which measures the voltage (U_{C2}) at the discharging capacitor (C2) and transmits it to the control circuit (ST),
at least one selection switch (T1 to Tn) is an N-MOSFET switch whose source terminal (S) is connected to the negative pole (GND) of the voltage source (SNT),
a diode (Da) conducting current to the discharging capacitor (C2) is located between the positive pole (+U_{SNT}) and the discharging capacitor (C2),
the drain terminal of the discharging switch (Te), which is in the form of an N-MOSFET switch, is connected, by way of a diode (Db) conducting current to it, to the cathode of the diode (Da), and whose source terminal is connected to the drain terminal (D) of each selection switch (T1 to Tn) by way of a decoupling diode (D1 to Dn) in each case, and
either a bypass switch (Bp) taking the form of an N-MOSFET switch and capable of being controlled by the control unit is provided whose drain terminal leads to the connection point between the ring-around coil (L) and the final control element (P1 to Pn), and whose source terminal is connected to the source terminal of the discharging switch (Te),
or a diode or Zener diode is provided whose cathode is connected to the ring-around coil (L) and whose anode is connected to the source terminal of the discharging switch (Te).

2. Device according to Claim 1, **characterised in that** the voltage source (SNT) takes the form of a switched-mode power supply which can be controlled by the control unit (ST).

3. Device according to Claim 1, **characterised in that** a diode (Dc) conducting current from the negative pole (GND) to the source terminal of the discharging switch (Te) is provided.

4. Method for operating the device according to Claim 1, **characterised in that** discharging switch (Te) is switched to conducting if none of the selection switches (T1 to Tn) is switched to conducting.

5. Method for operating the device according to Claim 1, **characterised in that**, prior to the first actuation of a final control element (P1 to Pn) and between two final control element actuations whose time interval exceeds a pre-defined duration, the discharging capacitor (C2) is charged up or re-charged by the bypass switch (Bp) and one of the selection switches (T1 to Tn) being simultaneously switched to conducting and subsequently to non-conducting on at least one occasion until a voltage (U_{C2}) pre-defined by the control unit (ST) is present at the discharging capacitor (C2).

6. Method for operating the device according to Claim 1, **characterised in that** a final control element (P1 to Pn) is actuated for as long as the associated selection switch (T1 to Tn) is switched to conducting.

7. Method for operating the device according to Claim 1, **characterised in that** the output voltage (+U_{SNT}) from the voltage source (SNT) is controlled or regulated during operation in order to achieve a constant charging voltage (U_{C1} + U_{C2}) or a constant final control element voltage (Up).

8. Method for operating the device according to Claim 1, **characterised in that** the output voltage (+U_{SNT}) from the voltage source (SNT) is controlled or regulated during operation to the effect that a constant feed of charge or energy is supplied to the relevant actuated final control element (P1 to Pn).

9. Method for operating the device according to Claim 1, **characterised in that** the bypass switch (Bp) is switched to conducting if the final control element voltage (Up) exceeds a pre-defined limit value or if a circuit fault occurs.

10. Method for operating the device according to Claim 1, **characterised in that** the discharging switch (Te) is switched to non-conducting if the current flowing through its drain-source path or the voltage applied to it exceeds a pre-defined value.

## Revendications

1. Dispositif pour commander au moins un actionneur capacitif (P1 à Pn), plus particulièrement un injecteur de carburant d'un moteur à combustion interne d'un véhicule automobile, à l'aide d'un circuit de commande (ST), comprenant un condensateur de charge (C1) branché entre le pôle positif (+U_{SNT}) et le pôle négatif (GND) d'une source de tension (SNT) et un circuit série composé d'une bobine oscillatrice (L) et d'au moins un actionneur auquel est associé un sélecteur (T1 à Tn) branché en parallèle à ce condensateur de charge (C1), et comprenant un commutateur de décharge (Te), **caractérisé en ce**
**qu'**un condensateur de décharge (C2) est branché entre le condensateur de charge (C1) et la bobine oscillatrice (L),
**qu'**il est prévu un circuit de mesure (S&H) qui mesure la tension (U_{C2}) aux bornes du condensateur de décharge (C2) et la communique au circuit de commande (ST),
**que** l'au moins un sélecteur (T1 à Tn) est un commutateur MOSFET N dont la borne de source (S) est reliée au pôle négatif (GND) de la source d'alimentation (SNT),
**qu'**une diode (Da) passante en direction du condensateur de décharge (C2) est branchée entre le pôle positif (+U_{SNT}) et le condensateur de décharge (C2), que la borne de drain du commutateur de décharge (Te) réalisé sous la forme d'un commutateur MOSFET N est reliée à la cathode de la diode (Da) par le biais d'une diode (Db) passante dans sa direction et dont la borne de source est reliée à la borne de drain (D) de chaque sélecteur (T1 à Tn), respectivement par le biais d'une diode de découplage (D1 à Dn), et que
soit il est prévu un commutateur de dérivation (Bp), réalisé sous la forme d'un commutateur MOSFET N et pouvant être commandé par l'appareil de commande, dont la borne de drain est reliée au point de jonction entre la bobine oscillatrice (L) et l'actionneur (P1 à Pn) et dont la borne de source est reliée avec la borne de source du commutateur de décharge (Te),
soit il est prévu une diode ou une diode zener dont la cathode est reliée à la bobine oscillatrice (L) et dont l'anode est reliée avec la borne de source du commutateur de décharge (Te).

2. Dispositif selon la revendication 1, **caractérisé en ce que** la source de tension (SNT) est réalisée sous la forme d'une alimentation à découpage pouvant être commandée par l'appareil de commande (ST).

3. Dispositif selon la revendication 1, **caractérisé en ce qu'**il est prévu une diode (Dc) passante du pôle négatif (GND) vers la borne de source du commutateur de décharge (Te).

4. Procédé pour faire fonctionner le dispositif selon la revendication 1, **caractérisé en ce que** le commutateur de décharge (Te) devient passant lorsque aucun des sélecteurs (T1 à Tn) n'est passant.

5. Procédé pour faire fonctionner le dispositif selon la revendication 1, **caractérisé en ce qu'**avant le premier actionnement d'un actionneur (P1 à Pn) et entre deux actionnements d'un actionneur dont l'écart dans le temps dépasse une durée prédéfinie, le condensateur de décharge (C2) est chargé ou rechargé, le commutateur de dérivation (Bp) et l'un des sélecteurs (T1 à Tn) devenant au moins simultanément passants et ensuite bloqués jusqu'à ce qu'une tension (U_{C2}) prédéfinie par l'appareil de commande (ST) soit présente aux bornes du condensateur de décharge (C2).

6. Procédé pour faire fonctionner le dispositif selon la revendication 1, **caractérisé en ce qu'**un actionneur (P1 à Pn) est rendu actif tant que le sélecteur associé (T1 à Tn) est passant.

7. Procédé pour faire fonctionner le dispositif selon la revendication 1, **caractérisé en ce que** pendant le fonctionnement, la tension de sortie (+U_{SNT}) de la source de tension (SNT) est commandée ou régulée à une tension de charge (UC1 + UC2) constante ou à une tension d'actionneur (Up) constante.

8. Procédé pour faire fonctionner le dispositif selon la revendication 1, **caractérisé en ce que** pendant le fonctionnement, la tension de sortie (+U_{SNT}) de la source de tension (SNT) est commandée ou régulée de manière à acheminer une charge ou une énergie constante à l'actionneur (P1 à Pn) à rendre actif.

9. Procédé pour faire fonctionner le dispositif selon la revendication 1, **caractérisé en ce que** le commutateur de dérivation (Bp) est rendu passant lorsque la tension d'actionneur (Up) dépasse une valeur de seuil prédéfinie ou s'il se produit un défaut de commutation.

10. Procédé pour faire fonctionner le dispositif selon la revendication 1, **caractérisé en ce que** le commutateur de décharge (Te) devient bloqué lorsque le courant qui passe à travers sa branche drain-source ou lorsque la tension appliquée à ses bornes dépasse une valeur prédéfinie.
